# EUROPEAN PATENT APPLICATION

(11) **EP 4 553 947 A1**
(43) Date of publication of application: **14.05.2025**
(21) Application number: 23835755.2
(22) Date of filing: 29.06.2023
(51) Int. Cl.: H01M 10/42, G01R 31/364, G01R 31/385, G01R 31/382, G01R 31/392, G01N 29/07, G01N 29/48

(54) **BATTERY TESTING DEVICE AND OPERATION METHOD THEREFOR**

(30) Priority: 05.07.2022 KR 20220082736
(71) Applicant: LG Energy Solution, Ltd., Seoul 07335 (KR)
(72) Inventor: SONG, Hyeon Jin, Daejeon 34122 (KR)
(74) Representative: Goddar, Heinz J.
(86) International application number: PCT/KR2023/009168
(87) International publication number: WO 2024/010288

(57) **Abstract**

A battery testing apparatus according to an embodiment includes a connector connected to an electrode of a battery cell, a charging/discharging unit configured to charge or discharge the battery cell through the connector, an ultrasonic sensing unit configured to output an ultrasonic signal toward the battery cell and sense an ultrasonic signal passing through the battery cell, and a controller configured to determine a state of the battery cell based on characteristics of the ultrasonic signal passing through the battery cell, during charge or discharge of the battery cell.

## Description

### [TECHNICAL FIELD]

### CROSS-REFERENCE TO RELATED APPLICATION

This application claims priority to and the benefit of Korean Patent Application No. 10-2022-0082736 filed in the Korean Intellectual Property Office on July 5, 2022, the entire contents of which are incorporated herein by reference.

### TECHNICAL FIELD

Embodiments disclosed herein relate to a battery testing apparatus and an operating method of the battery testing apparatus.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among them, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

A charge/discharge test refers to a method of testing a state of a battery by using a state parameter (e.g., voltage, current, temperature, resistance change, etc.) of the battery, obtained during charge or discharge of the battery, and has been widely used because of being capable of monitoring the remaining life or defect of a battery cell in a nondestructive manner. A gripper is used to electrically connect an electrode lead of a battery cell to a charger/discharger in a charge/discharge test, and an existing gripper, which is a member for simply passing current to the battery cell, does not have an additional function for diagnosing an internal state of the battery cell.

### [DISCLOSURE]

### [TECHNICAL PROBLEM]

Embodiments disclosed herein aim to provide a battery testing apparatus which monitors a change in characteristics of an ultrasonic signal passing through a battery cell while performing a charge/discharge test of the battery cell and determines a state of the battery cell based on the monitored change in the characteristics of the ultrasonic signal.

Technical problems of the embodiments disclosed herein are not limited to the above-described technical problems, and other unmentioned technical problems would be clearly understood by one of ordinary skill in the art from the following description.

### [TECHNICAL SOLUTION]

A battery testing apparatus according to an embodiment includes a connector connected to an electrode of a battery cell, a charging/discharging unit configured to charge or discharge the battery cell through the connector, an ultrasonic sensing unit configured to output an ultrasonic signal toward the battery cell and sense an ultrasonic signal passing through the battery cell, and a controller configured to determine a state of the battery cell based on characteristics of the ultrasonic signal passing through the battery cell, during charge or discharge of the battery cell.

In the battery testing apparatus according to an embodiment, the ultrasonic sensing unit may include an ultrasonic transmitter located inside the connector contacting an electrode lead at a side of the battery cell and configured to transmit the ultrasonic signal to the battery cell and an ultrasonic receiver located inside the connector contacting an electrode lead at an opposite side of the battery cell and configured to receive the ultrasonic signal passing through the battery cell.

In the battery testing apparatus according to an embodiment, the controller may be further configured to determine the state of the battery cell based on at least one of a speed change and an amplitude change of the ultrasonic signal.

In the battery testing apparatus according to an embodiment, the controller may be further configured to determine whether lithium is precipitated inside the battery cell, based on the characteristics of the ultrasonic signal.

In the battery testing apparatus according to an embodiment, the controller may be further configured to determine whether the electrode lead of the battery cell is defective, based on the characteristics of the ultrasonic signal.

In the battery testing apparatus according to an embodiment, the controller may be further configured to calculate at least one of a state of charge and a state of health of the battery cell, based on the characteristics of the ultrasonic signal and charge/discharge data of the battery cell.

The battery testing apparatus according to an embodiment may further include a liquid injector configured to form an ultrasonic medium layer between the electrode lead of the battery cell and the connector.

An operating method of a battery testing apparatus according to an embodiment includes charging or discharging a battery cell through a connector connected to an electrode of the battery cell, outputting an ultrasonic signal toward the battery cell, sensing an ultrasonic signal passing through the battery cell, and determining a state of the battery cell based on characteristics of the ultrasonic signal passing through the battery cell, during charge or discharge of the battery cell.

In the operating method of the battery testing apparatus according to an embodiment, the outputting of the ultrasonic signal toward the battery cell may be performed by an ultrasonic transmitter located inside the connector contacting an electrode lead at a side of the battery cell, and the outputting of the ultrasonic signal passing through the battery cell may be performed by an ultrasonic receiver located inside the connector contacting an electrode lead at an opposite side of the battery cell.

In the operating method of the battery testing apparatus according to an embodiment, the determining of the state of the battery cell may include determining the state of the battery cell based on at least one of a speed change and an amplitude change of the ultrasonic signal.

In the operating method of the battery testing apparatus according to an embodiment, the determining of the state of the battery cell may include determining whether lithium is precipitated inside the battery cell, based on the characteristics of the ultrasonic signal.

In the operating method of the battery testing apparatus according to an embodiment, the determining of the state of the battery cell may include determining whether the electrode lead of the battery cell is defective, based on the characteristics of the ultrasonic signal.

In the operating method of the battery testing apparatus according to an embodiment, the determining of the state of the battery cell may include calculating at least one of a state of charge and a state of health of the battery cell, based on the characteristics of the ultrasonic signal and charge/discharge data of the battery cell.

The operating method according to an embodiment may further include forming an ultrasonic medium layer between the electrode lead of the battery cell and the connector.

### [ADVANTAGEOUS EFFECTS]

With the battery testing apparatus according to an embodiment disclosed herein, the state of the battery cell may be determined by using the ultrasonic transducer and the ultrasonic sensor included in the connector (e.g., the gripper) connected to the electrode of the battery cell while charging/discharging the battery through the connector.

Conventional charge/discharge testers have estimated the battery state using only electric parameters of the battery cell, but according to an embodiment, the state of the cell, e.g., a state of charge, a state of health, whether lithium is precipitated, whether the electrode lead is defective, etc., may be more precisely estimated by using the characteristics of the ultrasonic signal passing through the battery cell as well as the electric parameters.

Moreover, various effects recognized directly or indirectly from the disclosure may be provided.

### [DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.
FIG. 1 is a block diagram showing a configuration of a battery testing apparatus according to an embodiment.
FIG. 2 is a schematic diagram showing a state in which a battery cell is tested using a battery testing apparatus according to an embodiment.
FIG. 3 is a plane view showing a connector of a battery testing apparatus according to an embodiment.
FIG. 4A is a graph showing a change in time-of-flight required for an ultrasonic signal to pass through a battery cell with respect to the number of charge/discharge cycles.
FIG. 4B is a graph showing a change in amplitude of an ultrasonic signal passing through a battery cell with respect to the number of charge/discharge cycles.
FIG. 5 is a flowchart showing an operating method of a battery testing apparatus according to an embodiment.
FIG. 6 illustrates a computing system that executes a battery testing method, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure. Moreover, terms defined in the present disclosure are used for only describing a specific exemplary embodiment and may not have an intention to limit the scope of other exemplary embodiments. It is to be understood that the singular forms include plural references unless the context clearly dictates otherwise.

Hereinbelow, preferred embodiments of a battery testing apparatus and an operating method thereof will be described with reference to the drawings.

Components shown in the block diagram are classified depending on their functions and roles, and each block does not necessarily have to be implemented as independent hardware or software. For example, separated components may be actually implemented as one device or program, or one component may be implemented as a combination of several devices and programs. Herein, expressions such as "first" and "second" are used to distinguish components from each other, and do not mean a rank or order among components.

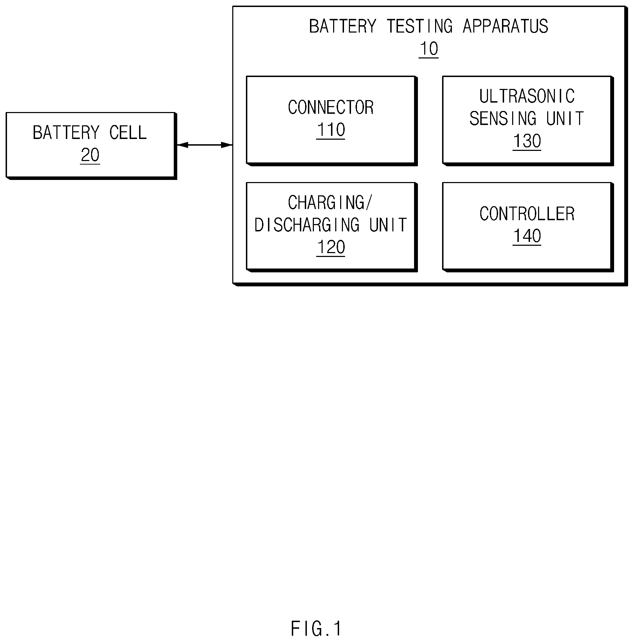

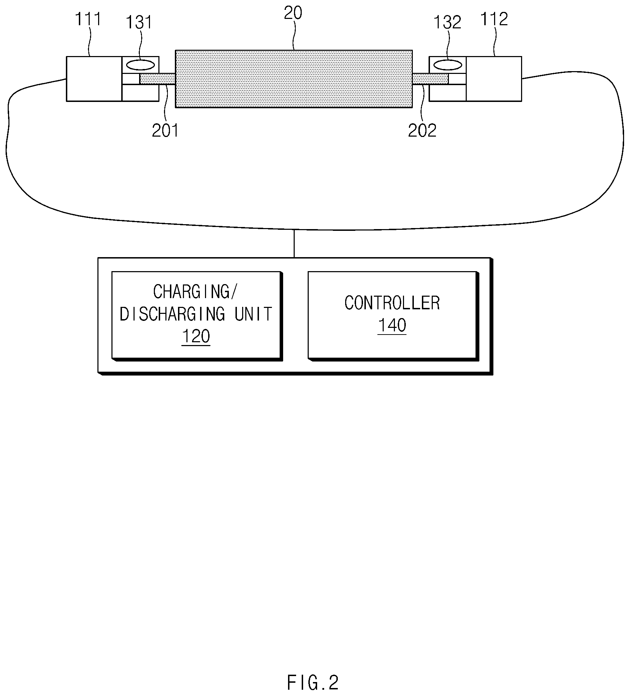

FIG. 1 is a block diagram showing a configuration of a battery testing apparatus according to an embodiment, and FIG. 2 is a schematic diagram showing a state in which a battery cell is tested using the battery testing apparatus.

Referring to FIG. 1, a battery testing apparatus 100 may include a connector 110 connected to an electrode of a battery cell 20, a charging/discharging unit 120 that charges or discharges the battery cell 20 through the connector 110, an ultrasonic sensing unit 130 that outputs an ultrasonic signal toward the battery cell 20 and senses the ultrasonic signal passing through the cell, and a controller 140 that determines a state of the battery cell 20 based on characteristics of the ultrasonic signal. Although not shown, the battery testing apparatus 10 may further include basic components (e.g., power for charge, load for discharge, a wire for electric connection between a battery cell and components, a control circuit for control of an apparatus, etc.) for conducting a charging/discharging test for a battery.

The battery cell 20 may have various forms, and a battery to which a technique disclosed herein is applied is not limited to a specific form or configuration. For example, the battery cell 20 may have a structure in which a plurality of mono-cells (battery basic units including a positive electrode, a negative electrode, and a separator) are stacked and enclosed by a pouch or a case, and may include an electrode lead for electrically connecting the positive electrode and the negative electrode of the battery cell to an external device. In FIG. 2, the battery cell 20 and electrode leads 201 and 202 protruding outwardly from the battery cell 20 are shown.

The connector 110 may be a member for electrically connecting the battery testing apparatus 10 to the battery cell 20 in contact with the electrode leads 201 and 202 of the battery cell 20. As shown in FIG. 2, the connector may include a first contact 111 and a second contact 112 respectively contacting the electrode leads 201 and 202, and a portion contacting an electrode lead may be formed of a metal material through which current flows.

For example, the connector 110 may be a gripper used to electrically contact a battery cell electrode in a charger/discharger. The contacts 111 and 112 of the connector may have a form of a clip or a clamp including a spring to firmly fix the electrode leads 201 and 202, respectively. The form of the shown connector is merely an example for helping understanding, and may be changed into another proper form according to a shape of the battery cell or a position of an electrode.

According to an embodiment, the battery testing apparatus 10 may further include a liquid injector (not shown) for forming an ultrasonic medium layer between the electrode leads 201 and 202 of the battery cell 20 and the contacts 111 and 112 of the connector. The ultrasonic signal have a transmission speed and a magnitude that change with a medium, and characteristics of a signal are highly likely to be distorted due to an air gap when an electrode lead and a connector (e.g., a gripper) do not closely contact each other. Thus, the liquid injector may inject a water-soluble couplant between the electrode lead and the connector to compress them and allow the ultrasonic signal to pass through the battery cell without the ultrasonic signal being distorted.

Referring back to FIG. 1, the charging/discharging unit 120 may charge or discharge the battery cell 20 through the connector 110 contacting the battery cell 20. According to an embodiment, the charging/discharging unit 120 may be configured to measure electrical parameter (current, voltage, impedance, etc.) of the battery cell 20 while charging or discharging the battery cell 20 at a preset C-rate. The measured parameter may be transmitted to the controller 140 and may be used to estimate a state of the battery cell 20 together with or independently of a result of analyzing the ultrasonic signal.

The ultrasonic sensing unit 130 may include an ultrasonic transmitter that transmits an ultrasonic signal toward the battery cell 20 and an ultrasonic receiver that receives an ultrasonic signal passing through the battery cell 20. According to an embodiment, the ultrasonic transmitter may be an ultrasonic transducer including a piezoelectric element for converting an electric signal provided from a power source into an ultrasonic signal, and the ultrasonic receiver may be an ultrasonic sensor for sensing an ultrasonic signal and converting the same into an electric signal. Although not shown, the ultrasonic sensing unit 130 may include additional components such as a power source for driving a transducer and a sensor, a pulse-generator, an oscilloscope, a switch, a control circuit for controlling them, etc.

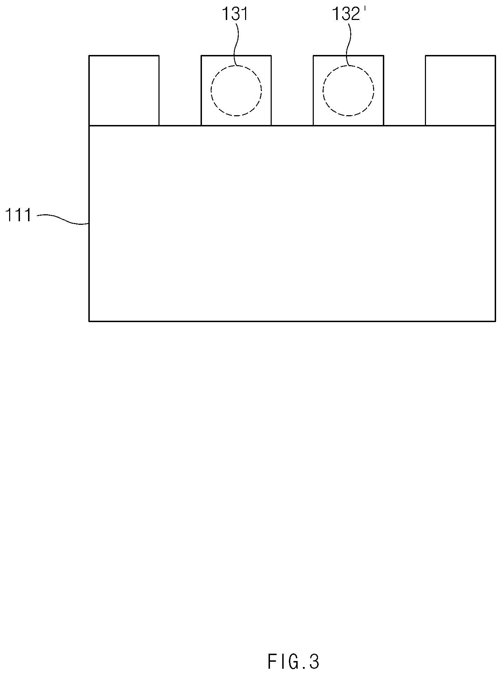

Referring to FIG. 2, the ultrasonic transmitter 131 may be positioned inside the first contact 111 of the connector contacting the electrode lead 201 at a side of the battery cell 20, and the ultrasonic receiver 132 may be positioned inside the second contact 112 of the connector contacting the electrode lead 202 at the opposite side of the battery cell 20. Alternatively, both the ultrasonic transmitter and the ultrasonic receiver may be included in each of the first contact 111 and the second contact 112 of the connector to output an ultrasonic wave toward the corresponding transmitter/receiver or sense the ultrasonic wave. For example, as shown in FIG. 3, the first contact 111 of the connector may include both the ultrasonic transmitter 131 and an ultrasonic receiver 132' for sensing an ultrasonic signal output from the ultrasonic transmitter positioned in the second contact 112 of the connector.

Referring back to FIG. 2, when the ultrasonic transmitter 131 positioned in the connector 111 contacting the electrode lead 201 at the side outputs the ultrasonic signal toward the battery cell 20, the ultrasonic receiver 132 positioned in the connector 112 contacting the electrode lead 202 at the opposite side may detect the ultrasonic signal. The ultrasonic sensing unit 130 may obtain characteristic information of an ultrasonic signal, such as amplitude changes of the output ultrasonic signal and the sensed ultrasonic signal, a time of flight required for the ultrasonic signal to pass through a battery cell, etc., and transmit the characteristic information to the controller 140.

The controller 140 may determine the state of the battery cell 20 based on characteristics of the ultrasonic signal sensed by the ultrasonic sensing unit 130 (e.g., a speed change, an amplitude change, etc., of the ultrasonic signal) or based on the characteristics of the ultrasonic signal and charge/discharge data (e.g., current, voltage, impedance data, etc., of a battery cell) obtained from the charging/discharging unit 120.

According to an embodiment, the controller 140 may determine whether lithium is precipitated inside a battery cell or an electrode lead of the battery cell is defective, based on the characteristics of the ultrasonic signal. According to another embodiment, the controller 140 may calculate a state parameter such as a state of charge, a state of health, etc., of the battery cell, based on the characteristics of the ultrasonic signal and the charge/discharge data of the battery cell.

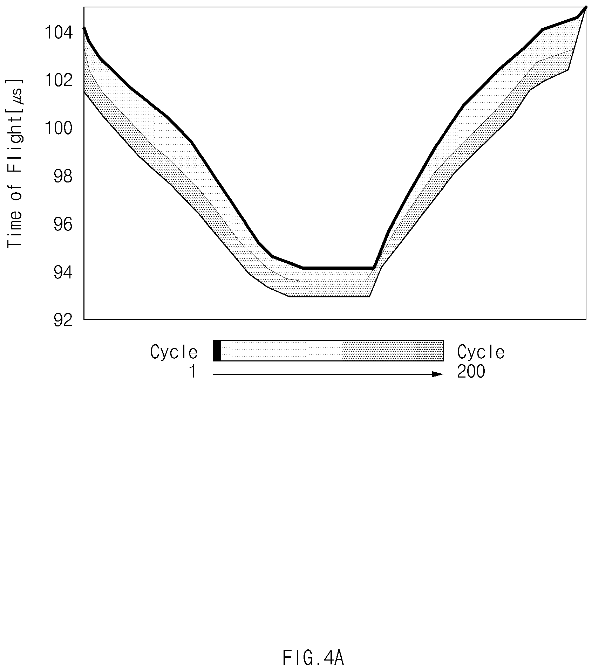

FIG. 4A is a graph showing a change in time-of-flight required for an ultrasonic signal to pass through a battery cell with respect to the number of charge/discharge cycles. The ToF may be calculated based on a difference between an output time of an ultrasonic wave and a sensing time of the ultrasonic wave of the ultrasonic sensing unit 130. Referring to FIG. 4A, it may be seen that as the number of charge/discharge cycles increases (i.e., the remaining lifetime decreases due to the use of a battery), the ToF decreases as a whole. This is because the speed of the ultrasonic signal passing through the battery cell increases due to lithium precipitation inside the cell, impedance increase, temperature increase, etc., as the battery is continuously used.

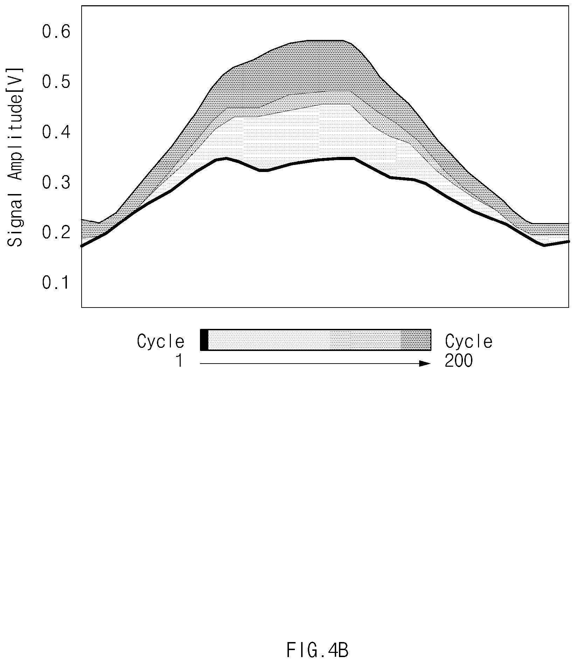

FIG. 4B is a graph showing a change in amplitude of an ultrasonic signal passing through a battery cell with respect to the number of charge/discharge cycles. Referring to FIG. 4B, it may be seen that as the number of charge/discharge cycles increases (i.e., the remaining lifetime decreases due to the use of a battery), the amplitude of the ultrasonic signal increases as a whole. This is because the intensity of the ultrasonic signal passing through the battery cell increases due to lithium precipitation inside the cell, impedance increase, temperature increase, etc., as the battery is continuously used.

According to an embodiment, when charge or discharge of the battery cell 20 is performed by the charging/discharging unit 120, the state of the battery cell may be more precisely estimated based on the characteristics of the ultrasonic signal measured by the ultrasonic sensing unit 130.

More specifically, a defect such as initial lithium precipitation of the battery cell may be observed in a specific charge section, but precipitated metal may dissolve and disappear after the corresponding section. In this case, abnormality may not be diagnosed by a general ultrasonic test conducted separately from a charge/discharge test of the battery cell, but according to an embodiment, the charge/discharge test and ultrasonic test may be performed at the same time through the ultrasonic sensor provided in the connector for the charge/discharge test, making diagnosis easy.

Moreover, conventionally, the ultrasonic test was performed by contacting an ultrasonic transducer to a body portion of the battery cell, in which especially, a pouch-type battery may have an internal defect due to deformation during compression of the transducer and the battery, and it may not be desirable to directly apply a couplant to the surface of the cell in terms of marketability.

According to an embodiment, a gripper may be coupled to an electrode lead portion instead of the surface of the cell to apply an ultrasonic signal, thereby solving the foregoing problems, and technical advantages may be provided such that not only an internal defect of the cell, but also a defect of the electrode or a defect in connection with other components may also be tested.

According to the battery testing apparatus described above, by simultaneously performing the charge/discharge test and the ultrasonic test on the battery by using the connector including the ultrasonic sensor, the state of the battery cell (lithium precipitation, electrode lead defect, remaining lifetime, etc.) may be determined according to the charge/discharge data and the characteristics of the ultrasonic signal.

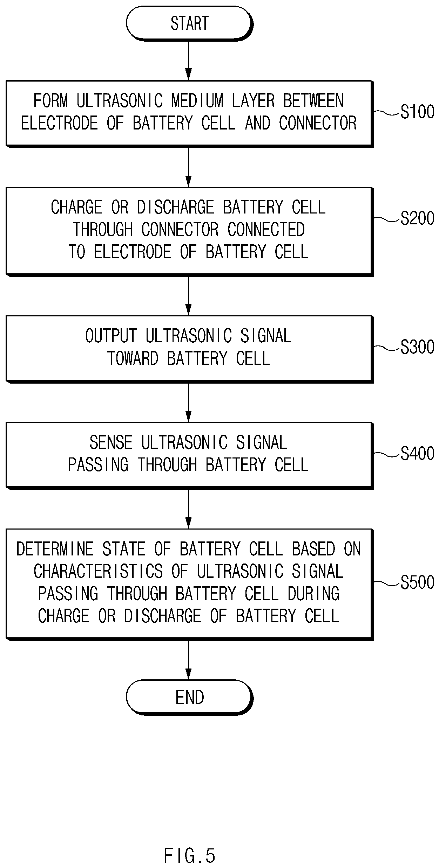

FIG. 5 is a flowchart showing an operating method of a battery testing apparatus according to an embodiment. Components of the battery testing apparatus 10 and the battery 20 have already been described with reference to FIGS. 1 to 3.

Referring to FIG. 5, in operation S100, an ultrasonic medium layer may be formed between an electrode of a battery cell and a connector. Operation S100 may be selectively performed by a liquid injector before or after the connector is brought into contact with the electrode of the battery cell. As the ultrasonic signal have a transmission speed and a magnitude that change with a medium, characteristics of a signal are highly likely to be distorted due to an air gap when the electrode lead and the connector do not closely contact each other. Thus, a water-soluble couplant may be injected between the electrode and the connector to compress them and the ultrasonic signal may be allowed to pass through the battery cell without the ultrasonic signal being distorted.

In operation S200, the battery cell may be charged or discharged through the connector connected to the electrode of the battery cell. According to an embodiment, the connector may be a gripper used to fix the battery electrode and the charger/discharger in a connected state in the battery charger/discharger, and a portion contacting the electrode may be formed of a metal material through which current flows.

According to an embodiment, the charging/discharging unit may measure electrical parameter (current, voltage, impedance, etc.) of the battery cell while charging or discharging the battery cell at a preset C-rate. The measured parameter may be transmitted and may be used to determine a state of the battery cell together with or independently of a result of analyzing the ultrasonic signal.

In operation S300, an ultrasonic signal may be output toward the battery cell. According to an embodiment, operation S300 may be performed by an ultrasonic transmitter located inside a first contact portion of the connector contacting the electrode lead at a side of the battery cell (see FIGS. 2 and 3). The ultrasonic transmitter may be an ultrasonic transducer including a piezoelectric element for converting an electric signal supplied from a power source into an ultrasonic signal.

In operation S400, the ultrasonic signal passing through the battery cell may be sensed. According to an embodiment, operation S400 may be performed by an ultrasonic receiver located inside a second contact portion of the connector contacting the electrode lead at the opposite side of the battery cell (see FIGS. 2 and 3), and the ultrasonic receiver may be an ultrasonic sensor for sensing the ultrasonic signal and converting the same into the electric signal.

In operation S500, during charge or discharge of the battery cell, the state of the battery cell may be determined based on characteristics of the ultrasonic signal sensed after passing through the battery cell.

According to an embodiment, operation S500 of determining the state of the battery cell may include an operation of determining the state of the battery cell based on characteristics of the ultrasonic signal such as a speed change, an amplitude change, of the ultrasonic signal, etc. For example, the ultrasonic sensing unit may obtain characteristic information of an ultrasonic signal, such as amplitude changes of the output ultrasonic signal and the sensed ultrasonic signal, a time of flight required for the ultrasonic signal to pass through a battery cell, etc., and the controller may estimate the state of the battery cell based on the same.

According to an embodiment, operation S500 of determining the state of the battery cell may include an operation of determining whether lithium is precipitated inside the battery cell or whether the electrode lead of the battery cell is defective, based on characteristics of the ultrasonic signal (e.g., a speed change, an amplitude change, of the ultrasonic signal, etc.). According to another embodiment, a state parameter such as a state of charge, a state of health, etc., of the battery cell, may be calculated based on the characteristics of the ultrasonic signal and the charge/discharge data of the battery cell (e.g., current, voltage, impedance data, etc., of the battery cell).

As described above with reference to FIGS. 4A and 4B, as the characteristics of the ultrasonic signal may change as the number of charge/discharge cycles of the battery cell increases (i.e., the remaining life decreases due to the use of the battery), the state of the battery cell may be estimated more precisely by using characteristic information such as the time (ToF) taken for the ultrasonic signal to pass through the battery cell, change in amplitude, etc., and charge/discharge data.

More specifically, by analyzing the change of the ultrasonic signal during charge or discharge of the battery cell, it is possible to detect abnormality that may be observed only in some charging sections, such as initial lithium precipitation. **In** this case, abnormality may not be diagnosed by a general ultrasonic test conducted separately from a charge/discharge test of the battery cell, but with a testing method according to an embodiment, the charge/discharge test and ultrasonic test may be performed at the same time through the ultrasonic sensor provided in the connector for the charge/discharge test, making diagnosis easy.

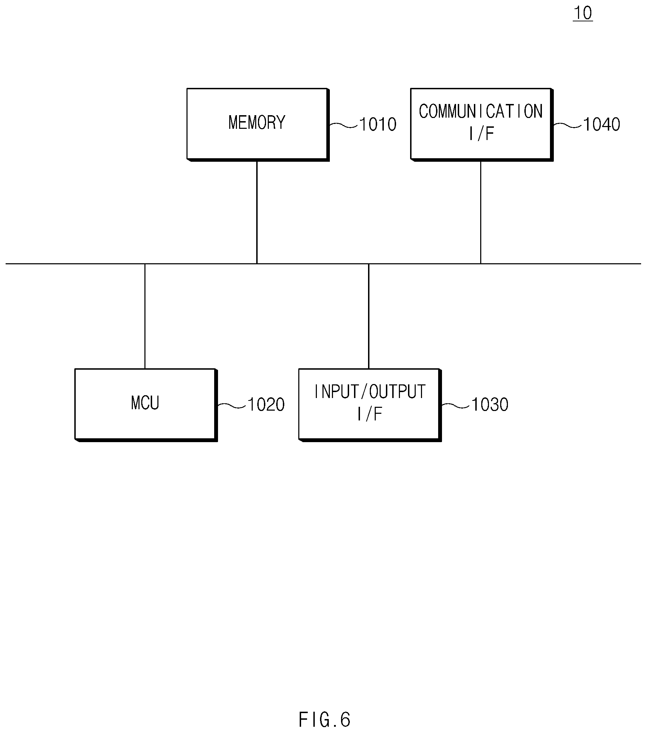

FIG. 6 is a plane view showing a hardware configuration of a battery testing apparatus according to an embodiment.

Referring to FIG. 6, a battery testing apparatus 10 may include a micro-controller (MCU) 1010 that performs various processing and control each component, a memory 1020 in which an operating system program and various programs are recorded, an input/output interface 1030 that provides an input interface and an output interface between a battery cell module and/or a semiconductor switching element, and a communication interface 1040 that may communicate with an external device through a wired/wireless communication network. As such, a computer program for execution of the battery testing apparatus may be recorded in the memory 1020 and processed by the micro-controller 1010, thus being implemented as a module that performs function blocks shown in FIGS. 1 and 2.

The operating method of the battery testing apparatus according to the embodiment may be implemented in the form of an application or a program instruction that is executable through various computer components and recorded in a computer-readable recording medium. The computer-readable recording medium may include a program instruction, a data file, a data structure and the like solely or in a combined manner.

So far, all components constituting the embodiment have been described as being combined or operating in combination, but it is not necessarily limited to this embodiment, and within the scope of the purpose, all components may be selectively combined with one or more to operate. Moreover, terms such as "include", "constitute", "have", etc., described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery testing apparatus comprising:
a connector connected to an electrode of a battery cell;
a charging/discharging unit configured to charge or discharge the battery cell through the connector;
an ultrasonic sensing unit configured to output an ultrasonic signal toward the battery cell and sense an ultrasonic signal passing through the battery cell; and
a controller configured to determine a state of the battery cell based on characteristics of the ultrasonic signal passing through the battery cell, during charge or discharge of the battery cell.

2. The battery testing apparatus of claim 1, wherein the ultrasonic sensing unit comprises:
an ultrasonic transmitter located inside the connector contacting an electrode lead at a side of the battery cell and configured to transmit the ultrasonic signal to the battery cell; and
an ultrasonic receiver located inside the connector contacting an electrode lead at an opposite side of the battery cell and configured to receive the ultrasonic signal passing through the battery cell.

3. The battery testing apparatus of claim 1, wherein the controller is further configured to determine the state of the battery cell based on at least one of a speed change and an amplitude change of the ultrasonic signal.

4. The battery testing apparatus of claim 3, wherein the controller is further configured to determine whether lithium is precipitated inside the battery cell, based on the characteristics of the ultrasonic signal.

5. The battery testing apparatus of claim 3, wherein the controller is further configured to determine whether the electrode lead of the battery cell is defective, based on the characteristics of the ultrasonic signal.

6. The battery testing apparatus of claim 3, wherein the controller is further configured to calculate at least one of a state of charge and a state of health of the battery cell, based on the characteristics of the ultrasonic signal and charge/discharge data of the battery cell.

7. The battery testing apparatus of claim 1, further comprising a liquid injector configured to form an ultrasonic medium layer between the electrode lead of the battery cell and the connector.

8. An operating method of a battery testing apparatus, the operating method comprising:
charging or discharging a battery cell through a connector connected to an electrode of the battery cell;
outputting an ultrasonic signal toward the battery cell;
sensing an ultrasonic signal passing through the battery cell; and
determining a state of the battery cell based on characteristics of the ultrasonic signal passing through the battery cell, during charge or discharge of the battery cell.

9. The operating method of claim 8, wherein the outputting of the ultrasonic signal toward the battery cell is performed by an ultrasonic transmitter located inside the connector contacting an electrode lead at a side of the battery cell, and
the outputting of the ultrasonic signal passing through the battery cell is performed by an ultrasonic receiver located inside the connector contacting an electrode lead at an opposite side of the battery cell.

10. The operating method of claim 8, wherein the determining of the state of the battery cell comprises determining the state of the battery cell based on at least one of a speed change and an amplitude change of the ultrasonic signal.

11. The operating method of claim 10, wherein the determining of the state of the battery cell comprises determining whether lithium is precipitated inside the battery cell, based on the characteristics of the ultrasonic signal.

12. The operating method of claim 10, wherein the determining of the state of the battery cell comprises determining whether the electrode lead of the battery cell is defective, based on the characteristics of the ultrasonic signal.

13. The operating method of claim 10, wherein the determining of the state of the battery cell comprises calculating at least one of a state of charge and a state of health of the battery cell, based on the characteristics of the ultrasonic signal and charge/discharge data of the battery cell.

14. The operating method of claim 8, further comprising forming an ultrasonic medium layer between the electrode lead of the battery cell and the connector.
